# EUROPEAN PATENT APPLICATION

(11) **EP 4 277 215 A1**
(43) Date of publication of application: **15.11.2023**
(21) Application number: 22172333.1
(22) Date of filing: 09.05.2022
(51) Int. Cl.: H04L 25/49, H04L 25/493, H04L 25/05, H03M 5/02, H04L 12/40

(54) **MODULE FOR A TRANSCEIVER**

(71) Applicant: NXP B.V., 5656 AG Eindhoven (NL)
(72) Inventor: Elend, Bernd Uwe Gerhard, 5656 AG Eindhoven (NL); de Haas, Clemens Gerhardus Johannes, 5656 AG Eindhoven (NL); Muth, Matthias Berthold, 5656 AG Eindhoven (NL); van der Heijden, Rigo Hendrikus Lambertus, 5656 AG Eindhoven (NL)
(74) Representative: Schmütz, Christian Klaus Johannes

(57) **Abstract**

The disclosure relates to a conversion module for a transceiver having a transmit input (TX), a receive output (RX) and network signalling terminals (LINE+, LINE-), the conversion module configured to: convert signals received at the transmit input from a first encoding scheme to a second, different, encoding scheme for providing to the network signalling terminals; and convert signals received at the network signalling terminals from the second encoding scheme to the first encoding scheme for providing to the receive output.

## Description

### Field

The present disclosure relates to data encoding conversion, and in particular although not exclusively concerns an Ethernet transceiver and associated method and computer program.

### Background

10BASE-T1S Ethernet is used in automotive applications. For some applications, it is difficult to achieve a suitable bit rate when communicating between nodes in networks with non-linear or complex wiring topologies. The apparatus and associated methods described herein may address this issue.

### Summary

According to a first aspect, there is provided a module for a transceiver having a transmit input (TX), a receive output (RX) and network signalling terminals (LINE+, LINE-), the module configured to:
convert signals received at the transmit input from a first encoding scheme to a second, different, encoding scheme for providing to the network signalling terminals; and
convert signals received at the network signalling terminals from the second encoding scheme to the first encoding scheme for providing to the receive output.

In one or more embodiments the second encoding scheme has a lower average number of signal state transitions per symbol than the first encoding scheme.

In one or more embodiments the first encoding scheme is Differential Manchester Encoding.

In one or more embodiments the second encoding scheme comprises one of NRZ, MLT3, HDB3 and PAM3.

In one or more embodiments the first encoding scheme comprises signals indicative of either a first logic state or a second logic state. The second encoding scheme may be a ternary encoding scheme, which may have a first level, a second level and a third level. The second encoding scheme may indicate a particular logic level by either transitioning or not transitioning between signal levels.

The first logic state may be different from the second logic state. The second encoding scheme may indicate logic high by transitioning between the signal levels. The second encoding scheme may indicate logic low by not transitioning between the signal levels.

Converting signals received at the transmit input from a first encoding scheme to a second, different, encoding scheme for providing to the network signalling terminals may comprises providing an outgoing transmission signal; generating the outgoing transmission signal at the same level between consecutive clock cycles in response to the transmit input indicating the first logic state; and transitioning the outgoing transmission signal to a different level in response to the transmit input having the second logic state, and select whether the transition is from the second level to the first level or the third level based on previous level values for the outgoing transmission signal.

The first level, second level and third level may be voltage levels, in which the first level is negative (-1), the third level is positive (+1) and the second level (0) is between the first level and the third level.

The previous logic levels may be determined by monitoring the average voltage of the outgoing transmission signal over a period of time.

In one or more embodiments the previous level values of the transmitter are determined by recording the amount of time that the outgoing transmission signal has been set to the first level or the third level in a number of bit periods.

The previous level values of the transmitter are determined by recording the number of times that the outgoing transmission signal has been set to the first level or the third level in a number of bit periods.

In one or more embodiments the module comprises a counter. The module may be further configured to increment the counter each time a bit of the outgoing transmission signal is provided at the third level. The module may be further configured to decrement the counter each time a bit of the outgoing transmission signal is provided at the first level. Selecting whether to transition from the second level to the first level or the third level is based on the value of the counter.

Selecting whether to transition from the second level to the first level or the third level may comprise electing to transition from the second level to the first level if the value of the counter is greater than a first threshold. Selecting whether to transition from the second level to the first level or the third level may comprise electing to transition from the second level to the third level if the value of the counter is less than a second threshold.

Selecting whether to transition from the second level to the first level or the third level based on previous logic levels of the transmitter may comprise electing to transition from the second level to the first level if the previous logic levels have a value greater than a first threshold. Selecting whether to transition from the second level to the first level or the third level based on previous logic levels of the transmitter may comprise electing to transition from the second level to the third level if the previous logic levels have a value less than a second threshold. The first threshold may be the same as or different from the second threshold. The first and second thresholds may be equal to zero.

In one or more embodiments the module is further configured to converting signals received at the network signalling terminals from the second encoding scheme to the first encoding scheme for providing to the receive output comprises: providing a signal at the receive output indicating the second logic state in response to an incoming transmission signal transitioning between different levels; and otherwise, providing a signal at the receive output indicating the first logic state.

In one or more embodiments the conversion module comprises an oscillator for providing the signal at the receive output indicative of Differential Manchester encoded bits. The module may be configured to generate an output pulse in response to a transition in the incoming transmission signal to a different logic level and one further output pulse per bit time.

In one or more embodiments the conversion module is configured to: detect the start of a transmission; determine a bit rate based on one or more bits at or near the beginning of the transmission; and perform the conversion of signals from the second encoding scheme to the first encoding scheme in accordance with the determined bit rate.

In one or more embodiments the conversion module is configured to use 5 bits or fewer than 5 bits at the start of the transmission to determine the bit rate. The system may be configured to use 5 bits or fewer bits within the first frame of the transmission.

In one or more embodiments determining a bit rate based on one or more bits comprises measuring a period of time between two consecutive signal edges within a first frame of the transmission. The module may comprise a local oscillator. The module may be configured to set a bit rate of the local oscillator in accordance with the period and its phase set in accordance with one or both of the signal edges.

According to a further aspect, there is provided an Ethernet transceiver comprising the conversion module of any preceding claim.

Logic implementing the conversion module may be built-in the transceiver. The Ethernet transceiver may be an 10BASE-T1S transceiver.

According to a further aspect, there is provided an Ethernet node comprising:
the conversion module of any of claims 1 to 13 or the Ethernet transceiver of claim 14; and
and one or more processors configured to provide the functionality of a media access controller, MAC, and Ethernet digital physical (digPHY) layer in accordance with IEEE802.3cg.

A further aspect relates to a vehicle comprising the Ethernet node.

According to a further aspect, there is provided a method for operating an Ethernet transceiver, the method comprising
converting signals, received at a transmit input of the transceiver, from a first encoding scheme to a second, different encoding scheme for providing to network signalling terminals of the transceiver; and
converting signals, received at the network signalling terminals, from the second encoding scheme to the first encoding scheme for providing to a receive output of the transceiver.

According to a further aspect, there is provided a transmitter for encoding an input indicative of a first logic state or a second logic state into a transmission signal of a ternary encoding scheme having a first level, a second level and a third level, wherein the encoding scheme permits transitions between the first and second level and transitions between the second and third levels, wherein the transmitter is configured to:
generate the transmission signal at the same level between consecutive clock cycles in response to the input indicating the first logic state; and
transition the transmission signal to a different logic level in response to the input having the second logic state, and select whether the transition is from the second level to the first level or the third level based on previous level values of the transmitter.

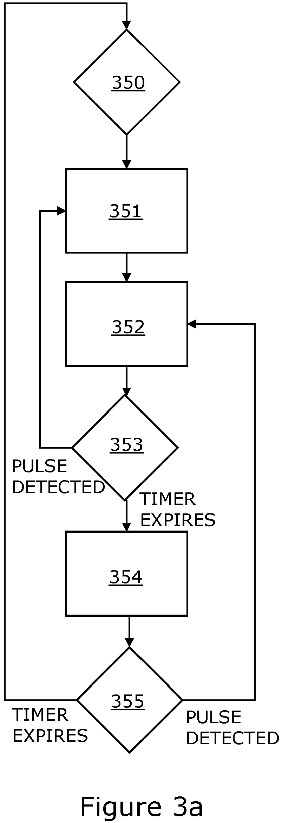

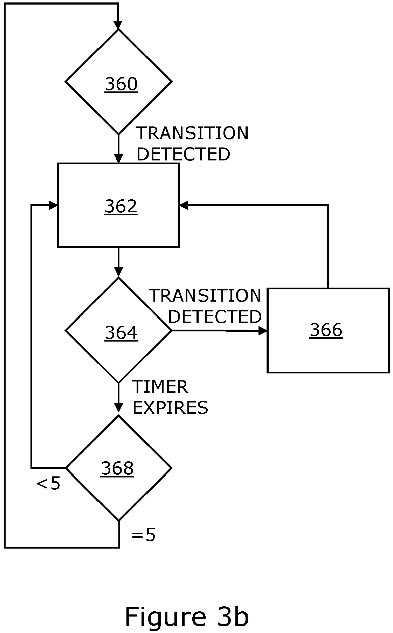

It will be appreciated that this aspect may be combined with any of the features described with respect to Figure 3, or the embodiments described with respect to the above aspect.

The encoding scheme may not permit a direct transition between the first level and the third level.

The first level, second level and third level may be voltage levels. The first level may be negative (-1), the third level may be positive (+1) and the second level (0) may be between the first level and the third level.

The previous logic levels of the transmitter may be determined by monitoring the average voltage of the transmission signal over a period of time.

The previous level values of the transmitter may be determined by recording amounts of time that the transmission signal has been set to the first level and the third level within a number of bit periods.

The previous level values of the transmitter may be determined by recording the number of times that the transmission signal has been set to the first level or the third level within a number of bit periods.

The previous level values of the transmitter may be determined by incrementing a counter each time a bit is provided at the third level and decrementing the counter each time a bit is provided at the first level.

Selecting whether to transition from the second level to the first level or the third level is based on a value of the counter.

Selecting whether to transition from the second level to the first level or the third level may comprise:
electing to transition from the second level to the first level if the value of the counter is greater than a first threshold; and
electing to transition from the second level to the third level if the value of the counter is less than a second threshold.

Selecting whether to transition from the second level to the first level or the third level based on previous logic levels of the transmitter may comprise electing to transition from the second level to the first level if the previous logic levels have a value greater than a first threshold. Selecting whether to transition from the second level to the first level or the third level based on previous logic levels of the transmitter may comprise electing to transition from the second level to the third level if the previous logic levels have a value less than a second threshold. The first threshold may be the same as or different from the second threshold. The first and second thresholds may be equal to zero.

The first logic state may be different from the second logic state. The first logic state may be logic low (0) and the second logic state may be logic high (1).

According to a further aspect, there is provided a receiver for decoding, into an output indicative of a first logic state or a second logic state, a transmission signal of a ternary encoding scheme having a first level, a second level and a third level, wherein the encoding scheme permits transitions between the first and second level and transitions between the second and third levels, wherein the receiver is configured to:
provide a signal at the receive output indicating the second logic state in response to the transmission signal transitioning between different levels; and
otherwise, provide a signal at the receive output indicating the first logic state.

Providing the output indicating the first logic state in response to the incoming transmission signal remaining at the same level between consecutive bits; and
provide the output indicating the second logic state in response to the incoming transmission signal transitioning to a different level.

The receiver may comprise an oscillator for providing an output signal indicative of logic low Differential Manchester encoded bits. The receiver may be configured to generate an output pulse in response to a transition in the transmission signal to a different logic level.

According to a further aspect, there is provided a method for encoding an input indicative of a first logic state or a second logic state into a transmission signal of a ternary encoding scheme having a first level, a second level and a third level, wherein the encoding scheme permits transitions between the first and second level and transitions between the second and third levels, the method comprising:
generating the transmission signal at the same level between consecutive clock cycles in response to the input indicating the first logic state; and
transitioning the transmission signal to a different logic level in response to the input having the second logic state, and select whether the transition is from the second level to the first level or the third level based on previous level values of the transmitter.

According to a further aspect, there is provided a method for decoding, into an output indicative of a first logic state or a second logic state, a transmission signal of a ternary encoding scheme having a first level, a second level and a third level, wherein the encoding scheme permits transitions between the first and second level and transitions between the second and third levels, the method comprising:
providing a signal at the receive output indicating the second logic state in response to the transmission signal transitioning between different levels; and
otherwise, providing a signal at the receive output indicating the first logic state.

According to a further aspect, there is provided a non-transitory computer-readable storage medium comprising computer program code configured to cause one or more processors to execute one or more methods disclosed herein.

According to a further aspect, there is provided an apparatus comprising:
one or more processors; and
a memory comprising computer program code configured to cause the one or more processors to execute one or more methods disclosed herein.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1a illustrates a schematic block diagram of an Ethernet network that may be used to implement the 10BASE-T1S protocol;
Figure 1b illustrates an example of an Ethernet transceiver connected to a signal line by network signalling terminals;
Figure 2a illustrates a timing diagram for the conversion between DME and NRZ encoding;
Figure 2b illustrates a timing diagram for the conversion between DME and MLT3 encoding;
Figure 3a illustrates a block diagram for implementing DME to MLT3 conversion;
Figure 3b illustrates a block diagram for implementing MLT3 to DME conversion;
Figure 4 illustrates a schematic block diagram for a state machine implementing a modified MLT3 coding scheme; and
Figure 5 illustrates a non-transitory computer-readable storage medium.

### Detailed Description

While much of the focus in recent Ethernet development has centred on high data rates, not every application requires speeds of up to 400 Gbps. For some applications, including Internet of Things (IoT), industrial and automotive, 10 Mbps is sufficient. Factors like cost, weight, distance and the space required for cable are more important for these use cases.

Recognizing these evolving requirements, IEEE began work in early 2017 to define IEEE 802.3cg, a standard for single-pair Ethernet that supports 10 Mbps. The goals of IEEE 802.3cg were to define a point-to-point and a multidrop short-distance standard with a maximum length of 25 meters, and a long-distance point-to-point standard that supports distances up to 1,000 meters. The resulting IEEE 802.3cg specification includes two link-layer standards: 10BASE-T1S and 10BASE-T1L.

The 10BASE-T1S short-range standard is primarily targeted at automotive and industrial applications. Multiple nodes on the network can share a cable in half-duplex shared-medium mode (multidrop mode) using the standard Ethernet Carrier-Sense Multiple Access with Collision Detection (CSMA/CD) access method or operate using PHY-Level Collision Avoidance (PLCA). The cable is an unshielded twisted pair (UTP) that may have multiple medium dependent interfaces (MDIs) attached thereto. As such, 10BASE-T1S may also be referred to as Multidrop Single Pair Ethernet (MSPE).

The 10BASE-T1L long-range option is designed for IoT and industrial control applications. The 1,000-meter range is sufficient for use in large factories or warehouses, and 10 Mbps is sufficient for gathering data from sensors and to monitor and control many types of industrial machinery. It shares the advantages of the short network variant: compatibility with four-pair Ethernet and lower cost, weight and required space.

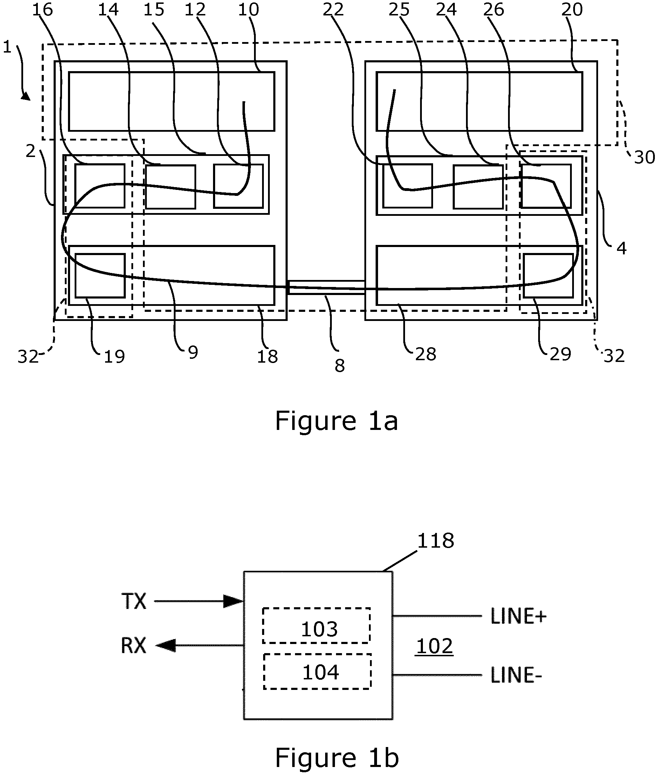

Figure 1a illustrates a schematic block diagram of an Ethernet network 1 that may be used to implement the 10BASE-T1S protocol. The network 1 comprises a first node 2 and a second node 4 connected by wire harness 8, which may be provided by a twisted pair of cables, for example.

Each node 2, 4 comprises an Ethernet stack including an Ethernet MAC 10, 20, a so called digPHY entity 15, 25 and a "PMD transceiver" 18, 28. Each digPHY entity 15, 25 provides various encoding or decoding functions as defined for the PCS Layer in IEEE802.3cg.

For example, when the first node 2 is acting as a transmitter and the second node 4 is acting as a receiver, the transmit digPHY entity 15 comprises a 4B5B encoder 12, a Differential Manchester Encoding (DME) encoder 14 and a pulse encoder 16 to provide a signal for the PMD transceiver 18 of the first node 2. Similarly, when the second node 4 is acting as a receiver, the receive digPHY entity 25 comprises a de-pulse decoder 26, an DME decoder 24 and a 4B5B decoder 22.

The PMD transceiver 18 acting in transmit mode comprises a de-pulse stage 19 configured to receive data from the transmit digPHY entity 15 of the first node 2, and the receive PMD transceiver 28 comprises a pulse stage 29 configured to provide a signal to the digPHY entity 25 of the second node 4.

Figure 1a further illustrates a data path from the Ethernet MAC 10 of the first node 2 to the Ethernet MAC 20 of the second node 4. The data path 9 passes sequentially from the transmit Ethernet MAC 10 to the transmit digPHY entity 15, passing through the 4B5B encoder 12, the DME encoder 14 and the pulse encoder 16, to the transmit PMD transceiver 18 comprising the de-pulse stage 19. The transmit PMD transceiver 18 encodes the signal for transmission on the wire harness 8, or network line, from the first node 2 to the second node 4 where it is received by the receive PMD transceiver 28. In the second node 4, the data path 9 passes from the receive PMD transceiver 28 having the pulse stage 29 to the receive digPHY entity 25, passing through the de-pulse stage 26, the DME decoder and the 4B5B decoder 22, to the receive Ethernet MAC 20.

Aspects 30 of the operation of the Ethernet system are defined by the IEEE 802.3cg standard and other aspects 32 are defined by the OpenAlliance TC14 standard.

Some aspects of the present disclosure are directed to aspects of the operation of the transceiver that are proposed to deviate from the IEEE 802.3cg standard.

Figure 1b shows one example of an Ethernet transceiver 118 connected to a signal line 102, or bus, by network signalling terminals. The signal line 102 comprises positive (LINE+) and negative (LINE-) lines formed as an unshielded twisted pair (UTP) suitable for conveying differential voltage signals, and the Ethernet transceiver 118 comprises a corresponding pair of signal pins configured for connection to the respective lines of the UTP.

The Ethernet transceiver 118 further comprises a transmitter module 103 for processing outgoing (egress) data into a suitable signal form for transmission to other nodes on the Ethernet network and a receiver module 104 for processing incoming signals from other nodes on the Ethernet network into a suitable data form for the higher layers of the protocol stack.

In this example, an Ethernet Physical Layer (PHY) is split into a digital PHY (digPHY) part and an analog frontend part, as described previously with reference to figure 1a. The PMD transceiver shown in Figure 1b is the analog front end part and is configured to interface with the digital PHY using three pins: a transmit pin TX for conveying outgoing data from the digital PHY to the transmission module 103 and a receive pin RX for conveying incoming (ingress) data from the receiver module 104 to the digital PHY.

10BASE-T1S as specified in IEEE802.3cg uses Differential Manchester Encoding (DME) on the physical medium.

In DME two signal changes may occur per bit. When used in combination with 4b/5b coding at 10 Mbit/s, this translates into a base frequency of 12.5 MHz and a minimum pulse width of 40 ns. The short pulse width of 40ns limits the network topology to strict linear topologies with a limited amount of nodes, while keeping the network bit rate fixed at 10Mbit/s.

The inventors have recognized that other coding schemes may be implemented that have few signal change per transmitted bit and (in combination with 4B5B coding) still allow for clock recovery at the receiver side. Using such an encoding scheme between the different nodes would allow higher bit rates and offers flexibility in wiring harness network topology.

An aspect of the present disclosure is directed to a conversion module which addresses the above problem by converting the DME signal provided by the digPHY entity of a 10BASE-T1S node to another encoding scheme for communication on the network. In this way, the network bus scheme (wiring harness) may be improved while maintaining Ethernet compatibility with other components.

A conversion module is configured to convert signals received at the transmit input from a first encoding scheme to a second, different, encoding scheme for providing to the network signalling terminals, and configured to convert signals received at the network signalling terminals from the second encoding scheme to the first encoding scheme for providing to the receive output. For a 10BASE-T1S system, the first encoding scheme is a form of Manchester coding, such as pulse coded DME, and the second encoding scheme may be selected to have a lower average number of signal state transitions per bit or symbol than the first encoding scheme. For example, DME has a base frequency that is a factor of 2.5 higher than NRZ coding; 10 Mbps NRZ coding translates into a base frequency of 5 MHz (minimum pulse width of 100 ns). It is preferable that the conversion technique is to another scheme that introduces little delay, perhaps of less than a bit period. For example, the second encoding scheme may be one of NRZ, MLT3, HDB3 and PAM3. Of these MLT3 has advantages for emission performance because it does not allow transitions between +1 and - 1 signalling.

Such conversion modules provides a sending PMD transceiver that drives a signal on the physical medium that is encoded other than with DME while being driven by an Open Alliance standard compliant pulse coded DME signal on its TX input and the receiving transceiver still provides a pulse coded DME signal on its RX output. In this way, DME can be exchanged, for example, by NRZ or MLT3 between nodes. This on-the-fly change of the signalling is performed in real time.

The conversion module may be provided together with, or separately from, other functionality of the PMD transceiver.

The conversion module may be provided in the PMD transceiver 118 of Figure 1b. In some examples, the conversion module may be provided by distributed components. For example, one or more first components that are configured to convert signals received at the transmit input may be provided separately from one or more second components that are configured to convert signals received at the network signalling terminals. In particular, the one or more first components may be associated with the transmission module 103 and the one or more second components may be associated with the receiver module 104.

In alternative examples, the conversion module may be provided separately from the transceiver 118. For example, a conversion module could be provided between the digPHY entity 15 and the PMD transceiver 18 described with reference to Figure 1a. For example, the conversion module may be provided between a conventional Ethernet transceiver and a conventional Ethernet digPHY, in which case the connections between the conversion module and the Ethernet digPHY are considered to provide the transmit input (TX) and receive output (RX) of the transceiver as a whole.

According to IEEE802.3/OpenAlliance TC14 a falling edge on TX pin (TX) of the PMD transceiver shall cause a state change of the bus, which is either driven to a positive or negative differential voltage. To stick with the two levels/one threshold approach the coding of the bit stream received on TX can be changed into NRZ coding,. A corresponding receiving transceiver performs a change in the coding back from NRZ to pulse coded DME. Not knowing whether the transmission will start with a logical "1" or a logical "0" means that the conversion needs to add a delay of at least half a bit time. Performing the conversion under the assumption that any transmission starts with a logical "0" allows conversion in real time (no delay)

In IEEE802.3/OpenAlliance TC14, any frame transmission and also the transmission of a Beacon starts with a logical "0" bit, so the assumption is correct in these two cases. While the HeartBeat (HB) using the 4B5B symbol T starts with a logical "1", HB is not decoded by receivers in multi-drop configuration of 10BASE-T1S. In multi-drop system, the symbol T is used in the Wake-up tone (WUT), here the assumption that a transmission starts with a "0" is wrong. In such cases, the leading "1" is replaced by a "0" when the delay-free conversion is performed at the transmitter side and cannot be corrected at the receiver side, which, however, is acceptable, since the detection of wake-up tones by the transceiver (transceiver) can also be guaranteed if the first of the six T symbols in the WUT is corrupt.

Conversion with half-bit delay: A first negative edge on the TX input starts a timer, if a second edge follows at approx. 50% of the bit time, then the bus needs to be driven with a positive differential voltage, else with a negative differential voltage. If the further edge follows the first edge significantly later than 50% of a bit time, then it can be considered to be a first edge.

Conversion in real time (no delay): Upon a first negative edge of a frame, the bus is driven with a negative differential voltage (assuming transmission starts with logical "0"). If a second edge follows at approx. 50% of the bit time it is to be ignored (transmission actually started with a logical "1") The following negative edges on TX shall be handled like in the "conversion with half a bit delay)

The RX output needs (independent of whether the tx adds half a bit delay or not) to show a pulse on a first edge after the bus being idle, each rising edge of the bus level and needs to toggle "fast" (2 times per bit time) when the bus has a positive differential voltage and "slow" (1 time per bit time) if the differential voltage is negative. (The differential bus voltage can alternatively operate on opposite polarities). In case the voltage on the bus remains around zero (no differential voltage), then the bus is idle and toggling at the receiver needs to stop.

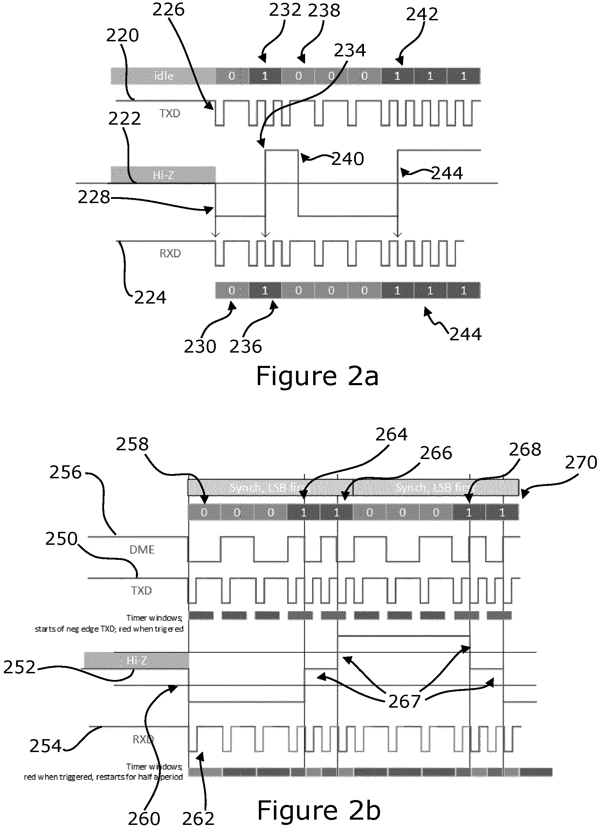

Figure 2a illustrates a timing diagram for the conversion without delay of a TX signal 220 at a first node, to an NRZ encoded signal 222 on the communication channel and converted back to a RX signal 224 at a second node.

The TX and RX signals representing Differential Manchester encoded signals provide one low pulse per cycle to represent logic low (0) and two low pulses per cycle to represent logic high (1). In NRZ, a negative signal (-1) represents logic low (0) and a positive sign (+1) represents logic high (1). In the idle state, the NRZ signal is set at zero.

The transmitter module in Figure 2a assumes that the first falling edge 226 of the TX signal 220 indicates the start of a '0' in accordance with the standard assumptions discussed above, and the NRZ signal is set negative (-1). The receiver module detects the first falling edge 228 of the NRZ encoded signal 222 and encodes the first bit 230 of the RX signal 224 accordingly as corresponding to logic low (0).

A second bit 232 of the TX signal 220 represents logic level '1'. The second falling edge of the second bit 232 is used to set a rising edge 234 of the NRZ encoded signal from negative (-1) to positive (+1). In response to the NRZ signal 222 transitioning to positive (+1), the receive encoder outputs two low pulses per cycle, representing a second bit 236 at logic high (1).

A third bit 238 of the TX signal 220 represents logic low (0). A falling edge 240 of the NRZ encoded signal from positive (+1) to negative (-1) is set half way through a period of the third bit 238, causing the receiver module to transition to outputting only 1 pulse per bit period.

The subsequent bits are also at logic low (0) so no change of the NRZ signal 222 occurs and the receive module continues to output 1 pulse per bit period.

A sixth bit 242 of the TX signal 220 represents logic level '1'. The third falling edge of the second bit 232 is used to set a rising edge 244 of the NRZ encoded signal from negative (-1) to positive (+1). In response to the NRZ signal 222 transitioning to positive (+1), the receive encoder outputs two low pulses per cycle, representing subsequent bits 244 at logic high (1)

Changing encoding on the bus from DME to NRZ comes with a disadvantage that NRZ is not DC-free and in worst case there are 8 consecutive bits of logical high "1" (4B5B coded 7 follows a 4B5B coded 0) and 4B5B having an average more logic high "1" than logic low "0" bits.

According to another example implementation, there is provided a PMD transceiver where the pulse coded DME signal is received for transmission and an MLT3 coded signal is actually transmitted on the medium and a received MLT3 coded signal from the medium is driving a pulse coded DME signal on its receiver output in real time. In such examples, MLT3 can be used instead of NRZ as discussed with reference to Figure 2a in order to improve the DC-balance and allow for improved clock recovery on the receiving side.

Where the absolute signal level of the signal in the NRZ scheme (-1; +1) indicates the logic level (0; 1), in MLT3 encoding, a transition between a signal level (e.g. -1 -> 0; 0 -> +1; +1 -> 0; 0 -> -1) indicates a logic high (1) and no transition between bit periods represents logic low (0). When using a MLT3 encoding on the bus, the logic state on the medium alternates in sequential order: 0 -> +1 -> 0 -> -1 -> 0, which reduces the signal frequencies on the wires compared to DME encoding significantly. The state of the signalling is advanced when a 1 is to be transmitted and stays constant when a "0" is to be transmitted. In, this way the run length is minimal when the bit stream is 4B5B code.

At the receiver side each change in MLT3 bus level causes a negative pulse on RX. One additional negative pulse per bit time may be generated at the receiver using an internal oscillator. Re-synch between the internal oscillator and the bus signal occurs, in the worst case, after 5 bit times because of the use of 4B5B coding in the Ethernet data. This worst case occurs when the bit stream has consecutive bits of logical "0" level. 4B5B coding guarantees a maximum run length of 4 bits in this case, which will occur as a period of 5 bit periods of the same level on the bus, because the bus level is changing in the mid of a bit time.

It can be exploited that any transmission on the bus can be started with a 0 (even though it starts with a 1 in case of a WUS); therefore a timer at the receiver may be started with a full bit period on the first change in bus level, while it is started with half a bit period on any proceeding change of the bus level. Once the timer is expired it is re-started with a full bit period. Pulses on RX are generated, when the timer expires or a change of the bus level occurs.

Pulse generation on RX can be aborted in case the received level remains 0 for more than 5 bit times. This denotes the end or abortion of the frame. Since the PCS layer in IEEE802.3 is specified to ignore any signalling on the bus after the end-of-stream indication that is neither SYNCH, HB or BEACON, so receiving the (invalid) 5B code 0000 will simply be ignored.

Figure 2b illustrates a timing diagram demonstrating a conversion of a TX signal 250 at a transmitter, to a MLT3 signal 252 on the bus, to a RX signal 254 at a receiver. A DME signal 256 is also illustrated for comparison with the MLT3 signal 252.

As described previously, the first bit 258 may be assumed to be a logic low (0) bit to avoid delays in the conversion. At the start of the first bit 258, the MLT3 signal 252 transitions from ground (0) to negative (-1). The receiver therefore treats the first change in sign 260 on the MLT3 signal 252 as a start of frame indicator and outputs pulse coded DME code indicative of a logic low (0) bit as a first bit 262. That is, the receiver outputs a signal with one negative pulse in a bit period to indicate logic low (0), which corresponds to the TXD signal 250 for the first bit 258. (In case we allow half a bit delay, the MLT3 signal could also start with a transition to +1 in case the first bit turns out to be a "1")

The second and third bits in this example are also logic low so no change is caused in the MLT3 code 252. The fourth and fifth bits 264, 266 are logic high bits, so the pulse coded Differential Manchester code on the TX signal 250 has two negative pulses per bit period. The second falling edge within the bit period on the TX signal triggers a change 267 in the level of the MLT3 signal 252. Similar changes 267 are also shown for the corresponding features of the ninth and tenth bits 268, 270. The changes 267 in the MLT3 code 252 cause an additional negative pulse to be produced in the RX signal 254 at the receiver. The result of these additional pulses is that the corresponding bits in the RX signal 254 contain two pulses per bit period, producing the same pulse coded Differential Manchester signal found in the TX signal 250.

By comparing the MLT3 signal 252 with the DME signal 256, both of which correspond to the TX signal 250, it can be seen that the MLT3 signal 252 has substantially fewer transitions to convey the same information, as would be expected from the preceding discussion.

Figures 3a and 3b illustrate schematic flow diagrams providing example schemes for operating a transmitter (Figure 3a) and a receiver (Figure 3b) for converting between pulse coded Differential Manchester encoded signals and MLT3 encoded signals, as described previously, for example, in figure 2b.

In figure 3a, the transmit side starts by determining whether a pulse has been detected on the TX signal on the transmit 350 input. If a pulse is detected then a transmission has started and the system proceeds to change 351 the voltage level on the bus, and starts a first timer 352. In this example, the first timer is for a period of 0.75 times the bit period, although it will be appreciated that a different value between about half a bit period and one bit period may be chosen. If a further pulse on the TX signal is detected 353 before the timer expires then the system returns to again change 351 the voltage level on the bus. Alternatively, if it is determined 353 that the timer has expired without a pulse being detected on the TX signal then instead the system proceeds to maintain 354 the voltage level on the bus at the same level and starts a second timer. The second timer may have a duration of 1 bit period, although it will be appreciated that another value greater than about 0.25 expect bit periods could be used.

If it is determined 355 that the second timer has expired without a pulse being detected, the transmission has ended and the process reverts to the start. The voltage level on the bus may be set to a high impedance state.

Alternatively, if it is determined 355 that a pulse has occurred before the second timer expires then the process reverts to restarting the first timer 352, and the process assesses the logic state of the next clock cycle as described above.

In Figure 3b the receive side process starts by detecting 360 a transition between voltage levels on the bus. If a transition between voltage levels on the bus is detected 360, then the process proceeds to generate 362 a pulse on the RX signal and starts a first timer. In this example, the first timer has a duration of 1 bit period.

If it is determined 364 that a transition is detected before the first timer expires, then the process proceeds to generate 366 a further pulse on the RX signal and start a second timer. In this example, the second timer is for half a bit period. On expiry of the second timer, the process reverts to generating 362 the pulse and restarting the first timer, and await a further transitions for detection.

However, if instead the first timer expires with no transition being detected, then it is determined how many times 368 the first timer has expired (or alternatively how long it has been since a transition has been detected). If the number of first timer expiries (or time since the detection of a transition) is less than a pre-determined value, then the process reverts to generating 362 the pulse and restarting the first timer, and await a further transitions for detection. Alternatively, if the number of times the first timer has expired (or period of time since a transition has been detected) is equal to the pre-determined value then the process reverts to a start. In this example, the pre-determined value is 5 bit periods because in the 4B5B scheme a transition would be expected to be received within 5 bit periods, so the absence of a transition for 5 bit periods indicates that the transmission has ended.

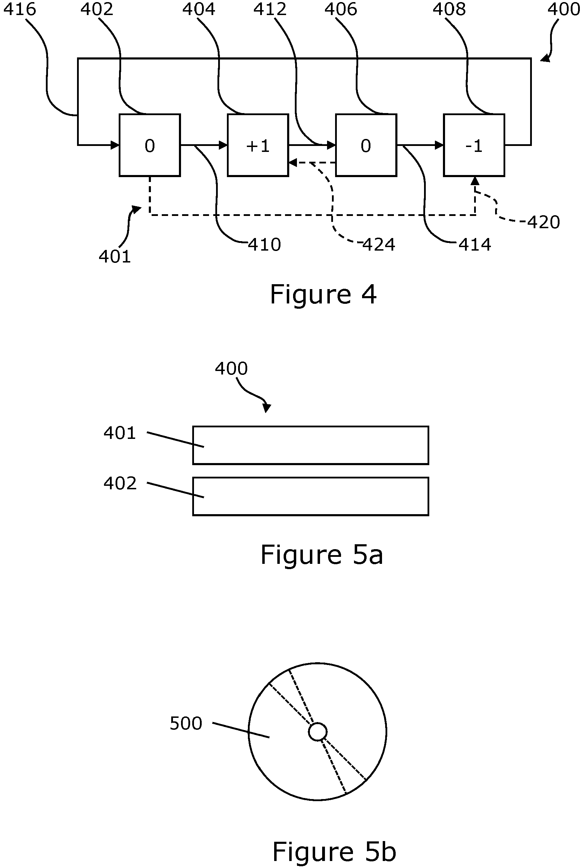

As discussed further below with reference to Figure 4, the MLT3 scheme cycles sequentially through the voltage levels -1, 0, +1, 0. In the MLT3 scheme, a transition to the next state in the sequence is used to transmit a logic high and no transition is used to transmit a logic low. MLT3 is used in combination with scrambling and 4B5B coding in Fast Ethernet (100BASE-TX) and is seen as considerably DC-free, but actually perfect DC-freedom is missing.

According to a further aspect of the present disclosure there is provided a modified coding scheme based on MLT3 that improves the DC-balance by reversing the order of occurrence of the output states in case one of the non-zero states has been assumed too often.

In such examples of such, if the encoded level is due to change from zero to +1 signaling, but the number of +1 signaled bits sent in the past is more than the number of -1 signalled bits plus a threshold, then the coding shall instead deviate from MLT3 and change to a -1 signalling.

Conversely, if the encoded level is due to change from zero to -1 signaling, but the number of -1 signaled bits sent in the past is more than the number of +1 signalled bits plus a threshold, then the coding shall deviate from MLT3 and change to a +1 signaling. The threshold may be zero or a positive value.

Figure 4 illustrates a schematic block diagram for a state machine implementing an MLT3 coding scheme 400 and modifications to the MLT3 coding scheme 401. The coding scheme is a ternary coding scheme having 4 physical (voltage) levels including a first level (-1), a second level (0) and a third level (+1). The state diagram includes four states and various transitions between the states. The states include a first state 402 at the second level (0), a second state 404 at the third level (+1), a third state 406 at the second level (0), and a forth state 408 at the first level (-1).

In the MLT3 coding scheme 400 when the input signal changes, that is changes from logical low '0' or logical high '1' or vice versa, the system changes state by progressing from the present state to the next state in the order first state 402, second state 404, third state 406, fourth state 408 and then returning to the first state 402 in a loop. In the illustrated diagram, a first transition 410 is provided between the first state 402 and the second state 404. A second transition 412 is provided between the second state 404 and the third state 406. A third transition 414 is provided between the third state 406 and the fourth state 408. A fourth transition 416 is provided closing of the loop from the fourth state 408 to the first state 402.

In the modifications to the coding scheme 401, alternative transitions to the first and third transitions 410, 414 are provided. In particular, a modified third transition 424 is provided as an alternative to the third transition 414, and a modified first transition 420 is provided as an alternative to the first transition 410. The modified third transition 424 causes the system to return from the third state 406 to the second state 404 following a transition instead of progressing to the fourth state 408. In the modified first transition 420, the system moves from the first state 402 to the fourth 408 upon a transition instead of to the second state 404. The modifications in the modified coding scheme 401 have the effect that the transition may be switched to the first state instead of the third state, or vice versa.

In the example described with reference to Figure 4, the first level, second level and third level are voltage levels. In a scheme in which the second level (0) is a voltage level that is higher than the first level (-1) and lower than the third level (+1), the modified coding scheme can be used to alter the overall average level occupied by the system. For example, if the system determines that in a previous number of bit or symbol periods the average voltage level occupied by the system is greater than a threshold level then it may be preferable to reduce the average level going forward by transitioning to a lower voltage level rather than a higher voltage level. Conversely, if the system determines that in a previous number of bit or symbol periods the average voltage level occupied by the system is less than a threshold level then it may be preferable to increase the average level going forward by transitioning to the higher voltage level rather than the lower voltage level.

The coding module described previously with reference to Figures 1a and 1b may be used to implement the modified MLT3 scheme described with reference to Figure 4. Alternatively, the modified coding scheme may be used for other applications.

In a general sense, there is provided a module for encoding a binary input into a transmission signal of a ternary encoding scheme having a first level, a second level and a third level, wherein the encoding scheme permits transitions between the first and second level and transitions between the second and third levels. The encoding scheme does not permit a direct transition between the first level and the third level.

The module is configured to generate the transmission signal at the same level between consecutive clock cycles in response to the input indicating the first logic state and transition the transmission signal to a different level in response to the input indicating the second logic state. It will be appreciated that voltages that are "the same level" encompass a range of voltages that fall within a band that are recognisable as corresponding to a physical layer level (e.g -1, 0, +1) as defined by the standard of the system.

When a transition is required, the module may select whether the transition is from the second level to the first level or the third level based on previous level values of the transmitter. In one example, the previous logic levels of the transmitter are determined by monitoring the average voltage of the transmission signal over a period of time. In another example, the previous level values of the transmitter are determined by recording the number of times that the transmission signal has been set to the first level or the third level within a number of bit periods. The previous level values of the transmitter may be determined by incrementing a counter each time a bit is provided at the third level and decrementing a counter each time a bit is provided at the first level. In such cases, selecting whether to transition from the second level to the first level or the third level is based on a value of the counter.

A corresponding module for a receiver may also be provided to decode, into an output indicative of the first logic state or the second logic state, the transmission signal of the ternary encoding scheme. In a general sense, the receiver is configured to provide the output indicating the first logic state in response to the transmission signal being either first or third level of the signalling and provide the output indicating the second logic state in response to the transmission signal transitioning to a different level.

In one example, the receiver module comprises an oscillator for providing an output signal indicative of logic low, such as low logic Differential Manchester encoded bits. Optionally, the receiver module is configured to resynchronize its oscillator based on the transmission signal transiting between levels. The receiver module is further configured to generate an output pulse in response to the transmission signal transitioning to a different logic level. As described with reference to an MLT3 example for Figure 2b, the further output pulse has the effect of providing two pulses in the output within a bit period (one from the oscillator and one triggered by the transmission signal transiting between levels, and so the output bit is a Differential Manchester-encoded logic high bit.

In each of the non-DME cases (NRZ, MLT3, modified MLT3), the module for the PMD transceiver acting as the receiver needs to know the bit rate on the bus to perform the signalling conversion correctly.

In some cases, the bit rate may be provided as *a priori* knowledge that is provided to each transceiver in a given system. Alternative, the bit rate may be determined by the receiver module.

According to a further aspect of the present disclosure there is provided a transceiver that is detecting the bit rate based on the first bits in a bit stream and adapting the (timing) behavior of the coding conversion accordingly. In a general sense, such modules may be configured to
i) detect the start of a frame on the network signalling terminals;
ii) determine a bit rate based on one or more bits at or near the beginning of the frame; and
iii) perform the conversion of signals from the second encoding scheme to the first encoding scheme in accordance with the determined bit rate.

Given that any 10BASE-T1S transmission starts with either a HB, SYNCH or BEACON symbol, the bit rate can be determined by the receiver module at the start of any transmission. For example, the receiver module may measure the length of the first bit or bits of a first frame of a message and adapt its timing behavior accordingly. If adaptation is needed, then the first received symbol will be corrupted, but IEEE802.3cg is tolerant to this. Preferably supported bit timings are defined in discrete steps, so that the measurement of the time yields an unambiguous result even in case the bus signal faces distortions. In such examples, possible bit rates may be known to the receiver module *a priori* and the actual bit rate is determined by comparing a measured period within the first frame (which may represent an integer number of bit periods) with the possible bit rates and their multiples. Further, in view of the use of 4B5B code in this system, the module may be configured to use 5 bits or fewer than 5 bits at the start of a transmission, which corresponds with a frame or less, to determine the bit rate to be used to decode subsequent frames. For example, if the first frame is a beacon (00010), the receiver module may measure the logic low period at the beginning of the frame as having a length of 78 ns. If possible know bit rates correspond to A: 50 ns, B: 80 ns and C: 120 ns, the module may determine that bit rate B is the closed that corresponds with the measured period. Bit rate B can then be used for the oscillator of the receiver module when decoding subsequent frames. The phase of the oscillator can be adjusted in accordance with subsequent edges of the signal.

Figure 5 illustrates a method 500 that may be performed within an Ethernet system comprising a plurality of nodes. For example, the method may be performed by the transceiver of each of the plurality of nodes. The method 500 comprises converting 501 signals, received at a transmit input of the transceiver, from a first encoding scheme to a second, different encoding scheme for providing to network signalling terminals of the transceiver and converting 502 signals, received at the network signalling terminals, from the second encoding scheme to the first encoding scheme for providing to a receive output of the transceiver.

Figure 5 illustrates a non-transitory computer-readable storage medium comprising computer program code configured to cause one or more processors to execute the method described previously with reference to Figure 4, or portions thereof, or any other method described herein. A such, an apparatus comprising one or more processors and a memory comprising the computer program code may also be provided.

While various examples herein relate to the use of a modified transceiver for communicating with a Ethernet digital physical (digPHY) layer in accordance with IEEE802.3cg, the disclosed transceivers may find other applications for replacing or modifying other systems that usually operated with a DME bus to achieve similar benefits.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A conversion module for a transceiver having a transmit input, a receive output and network signalling terminals,
the conversion module configured to:
convert signals received at the transmit input from a first encoding scheme to a second, different, encoding scheme for providing to the network signalling terminals; and
convert signals received at the network signalling terminals from the second encoding scheme to the first encoding scheme for providing to the receive output.

2. The conversion module of claim 1, wherein the second encoding scheme has a lower average number of signal state transitions per symbol than the first encoding scheme.

3. The conversion module of claim 1 or claim 2, wherein the first encoding scheme is Differential Manchester Encoding.

4. The conversion module of any preceding claim, wherein the second encoding scheme comprises one of NRZ, MLT3, HDB3 and PAM3.

5. The conversion module of any preceding claim, wherein the first encoding scheme comprises signals indicative of either a first logic state or a second logic state, wherein second encoding scheme is a ternary encoding scheme having a first level, a second level and a third level, and wherein the second encoding scheme indicates a particular logic level by either transitioning or not transitioning between signal levels.

6. The conversion module of claim 5, wherein converting signals received at the transmit input from a first encoding scheme to a second, different, encoding scheme for providing to the network signalling terminals comprises:
providing an outgoing transmission signal;
generating the outgoing transmission signal at the same level between consecutive clock cycles in response to the transmit input indicating the first logic state; and
transitioning the outgoing transmission signal to a different level in response to the transmit input having the second logic state, and select whether the transition is from the second level to the first level or the third level based on previous level values for the outgoing transmission signal.

7. The conversion module of claim 6, wherein the previous level values of the transmitter are determined by recording the amount of time that the outgoing transmission signal has been set to the first level or the third level in a number of bit periods.

8. The conversion module of claim 6 or claim 7, comprises a counter and is further configured to increment the counter each time a bit of the outgoing transmission signal is provided at the third level and decrement the counter each time a bit of the outgoing transmission signal is provided at the first level, wherein selecting whether to transition from the second level to the first level or the third level is based on a value of the counter.

9. The conversion module of any of claims 5 to 8, wherein converting signals received at the network signalling terminals from the second encoding scheme to the first encoding scheme for providing to the receive output comprises:
providing a signal at the receive output indicating the second logic state in response to an incoming transmission signal transitioning between different levels; and
otherwise, providing a signal at the receive output indicating the first logic state.

10. The conversion module of claim 8 comprising an oscillator for providing the signal at the receive output indicative of Differential Manchester encoded bits, wherein the module is configured to generate an output pulse in response to a transition in the incoming transmission signal to a different logic level and one further output pulse per bit time.

11. The conversion module of any preceding claim, further configured to:
detect the start of a transmission;
determine a bit rate based on one or more bits at or near the beginning of the transmission; and
perform the conversion of signals from the second encoding scheme to the first encoding scheme in accordance with the determined bit rate.

12. The conversion module of claim 11, wherein the system is configured to use 5 bits or fewer than 5 bits at the start of the transmission to determine the bit rate.

13. The conversion module of claim 11 or claim 12, wherein determining a bit rate based on one or more bits comprises measuring a period of time between two consecutive signal edges within a first frame of the transmission, and wherein a local oscillator of the module has its bit rate set in accordance with the period and its phase set in accordance with one or both of the signal edges.

14. An Ethernet transceiver comprising the conversion module of any preceding claim.

15. An Ethernet node comprising:
conversion module of any of claims 1 to 13 or the Ethernet transceiver of claim 14; and
and one or more processors configured to provide the functionality of a media access controller, MAC, and Ethernet digital physical layer in accordance with IEEE802.3cg.
